# FASCICULE DE BREVET EUROPEEN

(11) **EP 4 643 388 B1**
(45) Date de publication et mention de la délivrance du brevet: **09.12.2026**
(21) Numéro de dépôt: 23841031.0
(22) Date de dépôt: 20.12.2023
(51) Int. Cl.: H10W 70/65, H10W 90/00, H10W 70/60

(54) **MODULE DE PUISSANCE, AERONEF COMPORTANT UN TEL MODULE DE PUISSANCE ET PROCEDE DE FABRICATION DU MODULE DE PUISSANCE**
LEISTUNGSMODUL, LUFTFAHRZEUG MIT EINEM SOLCHEN LEISTUNGSMODUL UND VERFAHREN ZUR HERSTELLUNG DES LEISTUNGSMODULS
POWER MODULE, AIRCRAFT COMPRISING SUCH A POWER MODULE AND METHOD OF MANUFACTURING THE POWER MODULE

(30) Priorité: 28.12.2022 FR 2214573
(43) Date de publication de la demande: 05.11.2025
(73) Titulaire: Safran Electrical & Power, 31702 Blagnac (FR)
(72) Inventeur: BIAUJAUD, Rémy, 77550 Moissy-Cramayel (FR); SOUAHLIA, Rachid, 77550 Moissy-Cramayel (FR)
(74) Mandataire: Gevers & Orès
(86) Numéro de dépôt international: PCT/FR2023/052071
(87) Numéro de publication internationale: WO 2024/141733

(56) Documents cités:
- WO-A1-2018/194153
- WO-A1-2022/008121

## Description

### Domaine technique de l'invention

La présente invention concerne un module de puissance, un aéronef comportant un tel module de puissance et un procédé de fabrication du module de puissance.

### Arrière-plan technologique

On connait de l'état de la technique un module de puissance comportant :
- un substrat comportant :
   - une plaque isolante électrique présentant une face supérieure, et
   - des pistes conductrices électrique s'étendant sur la face supérieure ;
- un composant électrique fixé contre au moins une des pistes conductrices électriques ;
- une résistance fixée contre au moins une des pistes conductrices électriques ;
- une capacité connectée en série de la résistance ; et
- une encapsulation recouvrant :
   - au moins une partie des pistes électriques,
   - le composant électrique.

Dans certains modules de puissance, l'encapsulation recouvre la résistance et la capacité. C'est le cas par exemple d'un module selon WO 2018/194153 A1. Cependant, la capacité subit alors les contraintes thermiques et mécaniques présentes dans l'encapsulation, ce qui impose un dimensionnement important de cette dernière. Par exemple, le composant électrique fonctionne généralement jusqu'à 175°C, tandis qu'un condensateur classique ne fonctionne que jusqu'à 125°C. Il est donc nécessaire de prévoir un condensateur fonctionnant à plus haute température, et donc couteux.

Dans d'autres modules de puissance, comme c'est le cas par exemple dans un module selon WO 2022/008121 A1, la résistance et la capacité sont placées en dehors de l'encapsulation. Cependant, la résistance n'est alors plus refroidie au travers du substrat et risque ainsi de s'échauffer, et de chauffer par la même occasion l'environnement du module de puissance, où de l'électronique sensible peut se trouver.

Il peut ainsi être souhaité de prévoir un module de puissance qui permette de s'affranchir d'au moins une partie des problèmes et contraintes précités.

### Résumé de l'invention

Il est donc proposé un module de puissance :
- un substrat comportant :
   - une plaque isolante électrique présentant une face supérieure, et
   - des pistes conductrices électrique s'étendant sur la face supérieure ;
- un composant électrique fixé contre au moins une des pistes conductrices électriques ;
- une résistance fixée contre au moins une des pistes conductrices électriques ;
- une capacité connectée en série de la résistance ; et
- une encapsulation recouvrant :
   - au moins une partie des pistes électriques,
   - le composant électrique, et
   - la résistance. comportant en outre :
- deux broches présentant :
   - des bases fixées à deux des pistes conductrices, ces bases étant recouverte par l'encapsulation, et
   - des extrémités libres se projetant en-dehors de l'encapsulation ;
en ce que la capacité est placée en dehors de l'encapsulation, et connectée aux extrémités libres des broches.

Ainsi, la résistance reste à proximité du substrat et peut être refroidie au travers de ce dernier. En même temps, la capacité située en dehors de l'encapsulation n'est plus soumise aux contraintes thermiques et mécaniques sévères, et peut donc être normalement dimensionnée.

L'invention peut en outre comporter l'une ou plusieurs des caractéristiques optionnelles suivantes, selon toute combinaison techniquement possible.

De préférence, le module de puissance comporte en outre une carte de circuit imprimé s'étendant en dehors de l'encapsulation et recevant les extrémités libres des broches, et la capacité est fixée à la carte de circuit imprimé et connectée par cette dernière aux extrémités libres des broches.

De préférence également, la carte de circuit imprimé porte un circuit de commande du composant électrique.

De préférence également, le module de puissance comporte en outre une borne dite positive et une borne dite négative fixées respectivement à deux des pistes conductrices électriques et conçues pour présenter entre elles une tension continue, et la résistance et la capacité sont connectées ensemble entre la borne positive et la borne négative.

De préférence également, l'encapsulation est en résine.

De préférence également, le composant électrique est un composant électrique semiconducteur.

De préférence également, le module de puissance comporte plusieurs composants électriques semiconducteurs formant un bras de commutation.

Il est également proposé un aéronef comportant un module de puissance selon l'invention.

Il est également proposé un procédé de fabrication d'un module de puissance selon l'invention, comportant :
- une fixation du composant électrique contre au moins une des pistes conductrices électriques, de la résistance contre au moins une des pistes conductrices électriques et des bases des broches respectivement à deux des pistes conductrices électriques ;
- une encapsulation d'au moins une partie des pistes conductrices électriques, du composant électrique, de la résistance et des bases des broches ; et
- une connexion de la capacité aux extrémités libres des broches, en dehors de l'encapsulation.

De préférence, l'encapsulation est réalisée par moulage par transfert de résine.

### Brève description des figures

L'invention sera mieux comprise à l'aide de la description qui va suivre, donnée uniquement à titre d'exemple et faite en se référant aux dessins annexés dans lesquels :
- la figure 1 est un schéma électrique d'un module de puissance selon l'invention,
- la figure 2 est une vue tridimensionnelle du module de puissance, en l'absence de carte de circuit imprimé et de support de cette dernière,
- la figure 3 est une vue tridimensionnelle du module de puissance, avec la carte de circuit imprimé et le support de cette dernière,
- la figure 4 est une vue en coupe du module de puissance, et
- la figure 5 est un schéma-bloc d'un procédé de fabrication du module de puissance.

### Description détaillée de l'invention

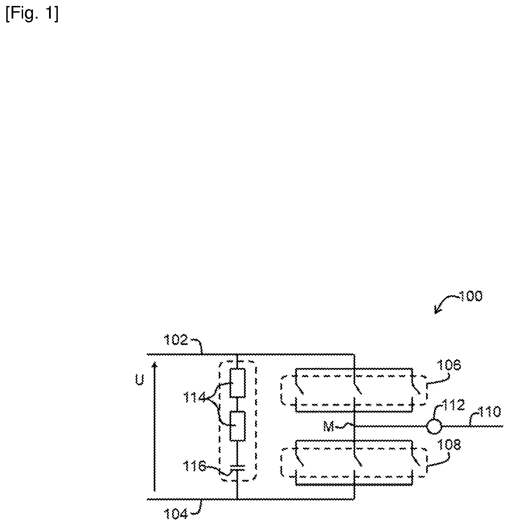

En référence à la figure 1, un exemple de module de puissance 100 selon l'invention va à présent être décrit.

Le module de puissance 100 comporte tout d'abord une borne positive 102 et une borne négative 104 conçues pour présenter entre elles une tension continue U.

Le module de puissance 100 comporte en outre au moins un composant électrique, par exemple semiconducteur. Par exemple, le module de puissance 100 implémente un bras de commutation connecté entre la borne positive 102 et la borne négative 104.

Le bras de commutation comporte un ou plusieurs interrupteurs semiconducteurs de côté haut 106 en parallèle (trois dans l'exemple illustré) et un ou plusieurs interrupteurs semiconducteurs de coté bas 108 en parallèle (trois dans l'exemple illustré). Les interrupteurs de côté haut 106 et les interrupteurs de côté bas 108 sont connectés en un point milieu M. Le module de puissance 100 comporte alors en outre une borne alternative 110 connectée au point milieu M pour présenter une tension alternative.

Chaque interrupteur 106, 108 est de préférence un interrupteur commandable à semi-conducteur, comme par exemple un transistor à effet de champ à grille métal-oxyde (de l'anglais « Metal Oxide Semiconductor Field Effect Transistor » également désigné par l'acronyme MOSFET) ou bien un transistor à effet de champ à grille métal-oxyde silicium (de l'anglais « Silicon Metal Oxide Semiconductor Field Effect Transistor » également désigné par l'acronyme Si MOSFET) ou bien un transistor à effet de champ à grille métal-oxyde au carbure de silicium (de l'anglais « Silicon Carbide Metal Oxide Semiconductor Field Effect Transistor » également désigné par l'acronyme SiC MOSFET) ou bien un transistor bipolaire à grille isolée (de l'anglais « Insulated Gate Bipolar Transistor » également désigné par l'acronyme IGBT) ou bien un transistor à effet de champ au nitrure de gallium (de l'anglais « Gallium Nitride Field Effect Transistor » également désigné par l'acronyme GaN FET).

Le module de puissance 100 peut en outre comporter un capteur de courant 112 sur la borne alternative 110.

Le module de puissance 100 comporte en outre au moins une résistance 114 et au moins une capacité 116, connectées en série par exemple entre la borne positive 102 et la borne négative 104. La résistance 114 et la capacité 116 forme ainsi un circuit passif d'aide à la commutation des interrupteurs 106, 108, appelé « snubber » en anglais. La capacité 116 sert à atténuer les surtensions de la tension continue U et la résistance 114 sert à dissiper l'énergie emmagasinée dans la capacité 116 et à amortir la résonnance.

La capacité 116 comporte en particulier au moins un condensateur, par exemple un condensateur céramique.

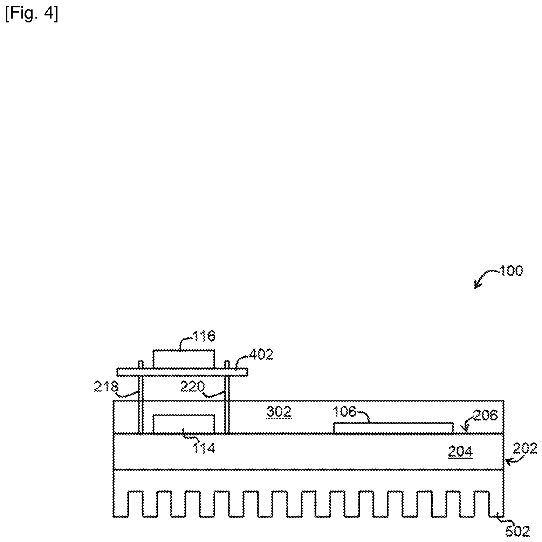

En référence à la figure 4, le module de puissance 100 comporte un substrat 202 comportant : une plaque isolante électrique 204 présentant une face supérieure 206, et des pistes conductrices électrique s'étendant sur la face supérieure 206.

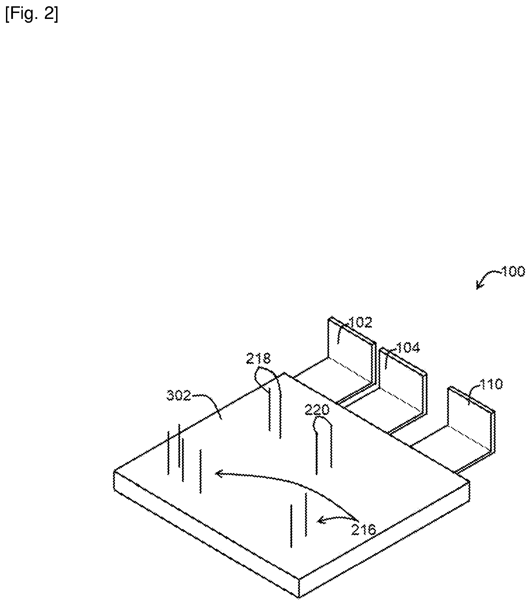

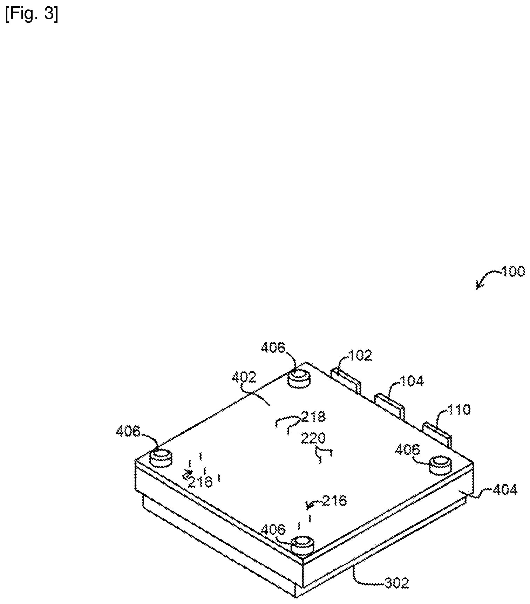

Les pistes conductrices électriques comportent en particulier une piste dite positive à laquelle la borne positive 102 est fixée (par exemple par soudure), une piste dite négative à laquelle la borne négative 104 est fixée (par exemple par soudure), une piste dite alternative à laquelle la borne alternative 110 est fixée (par exemple par soudure), ainsi que des première et deuxième pistes auxiliaires. Les pistes conductrices électriques peuvent en outre comporter des pistes de commande des interrupteurs 106, 108 d'où s'élèvent des broches de commande 216 (visibles sur les figures 2 et 3).

Les interrupteurs de côté haut 106 sont ainsi connectés entre la piste positive et la piste alternative. Par exemple, les interrupteurs de côté haut 106 sont fixés (par exemple par soudure) contre la piste positive et connectés à la piste alternative par des fils conducteurs ou bien des rubans conducteurs. Les interrupteurs de côté bas 108 sont connectés entre la piste négative et la piste alternative. Par exemple, les interrupteurs de côté bas 108 sont fixés (par exemple par soudure) contre la piste alternative et connectés à la piste négative par des fils conducteurs ou bien des rubans conducteurs.

Par ailleurs, la ou les résistances 114 sont connectées en série entre la première piste auxiliaire et l'une parmi la piste positive et la piste négative. Par exemple, la première résistance 114 est fixée (par exemple par soudure) à la première piste auxiliaire et à la deuxième piste auxiliaire et la deuxième résistance 114 est fixée (par exemple par soudure) à la deuxième piste auxiliaire et la piste négative. Les résistances 114 sont ainsi de préférence des composants SMT (de l'anglais « Surface Mount Technology »). Alternativement, chaque résistance 114 pourrait être fixée (par exemple par soudure) à une seule des deux pistes conductrices électriques et connectée à l'autre par au moins un fil conducteur électrique ou bien au moins un ruban conducteur électrique.

En référence aux figures 3 à 5, le module de puissance 100 comporte en outre au moins deux broches 218, 220 présentant des bases fixées (par exemple par soudure) à deux des pistes conductrices électriques. Par exemple, au moins une des broches 218, 220 présente une base fixée à l'une parmi la piste positive et la piste négative. Toujours par exemple, au moins une autre des broches 218, 220 présente une base fixée à la première piste auxiliaire. Les broches 218, 220 s'élèvent par exemple sensiblement perpendiculairement à la face supérieure 206 du substrat 202.

En référence à la figure 2, le module de puissance 100 comporte en outre une encapsulation 302 recouvrant : au moins une partie des pistes conductrices électriques, les interrupteurs 106, 108, les résistances 114 et les bases des broches 216, 218, 220 étant recouvertes par l'encapsulation 302. L'encapsulation 302 est par exemple réalisée par moulage par transfert de résine, comme dans l'exemple illustré. Alternativement, l'encapsulation 302 pourrait comporter un boîtier, par exemple collé sur la face supérieure 206 du substrat 202, ce boîtier étant rempli de gel.

En revanche, les extrémités libres des broches 216, 218, 220 se projettent en-dehors de l'encapsulation 302.

En référence à la figure 3, le module de puissance 100 comporte en outre une carte de circuit imprimé 402 s'étendant au-dessus de l'encapsulation et recevant les extrémités libres des broches 216, 218, 220. La carte de circuit imprimé 402 porte par exemple un circuit (non représenté) de commande des interrupteurs 106, 108 par les broches de commande 216.

Le module de puissance 100 comporte en outre par exemple un support 404 de la carte de circuit imprimé 402, ainsi que des vis 406 de fixation de ce support 404 au substrat 202.

En référence à la figure 4, la capacité 116 est fixée (par exemple par soudure) à la carte de circuit imprimé 402, en dehors de l'encapsulation 302, et connectée par cette dernière aux extrémités libres des broches 218, 220. Ainsi, grâce à l'utilisation des broches 218, 220, la distance entre la capacité 116 et les résistances 114 peut être réduite au maximum, tout en respectant les distances d'isolement nécessaire. La capacité 116 et les résistances 114 sont ainsi connectées au plus près des composants électrique de puissance 106, 108.

Par ailleurs, le module de puissance 100 comporté en outre par exemple un dissipateur thermique 502 fixé contre une face inférieure 504 de la plaque isolante électrique 204 du substrat 202.

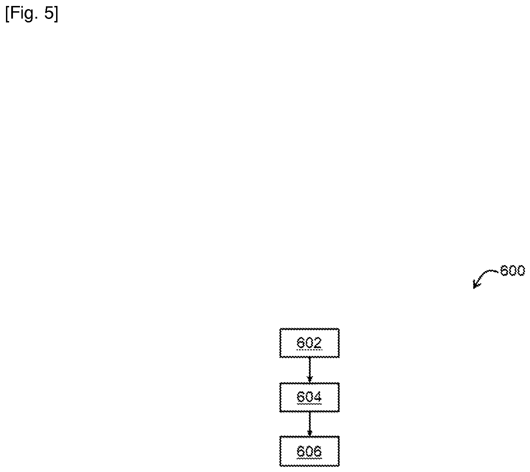

En référence à la figure 5, un exemple d'un procédé 600 de fabrication du module de puissance 100 va à présent être décrit.

Au cours d'une étape 602, les interrupteurs 106, 108 sont fixés contre les pistes conductrices électriques, les résistances 114 sont fixées contre les pistes conductrices électriques et les bases des broches sont fixées respectivement aux pistes conductrices électriques.

Au cours d'une étape 604, l'encapsulation 302 est réalisée, par exemple par moulage par transfert de résine.

Au cours d'une étape 606, la capacité 116 est connectée aux extrémités libres des broches 218, 220, en dehors de l'encapsulation 302.

Il apparaît clairement qu'un module de puissance tel que celui décrit précédemment permet d'utiliser un snubber avec une résistance suffisamment refroidie, tout en utilisant un condensateur habituel. En outre, le placement de la capacité évite sa détérioration lors de l'injection de résine du moulage par transfert de résine. En effet, lors de l'injection, un condensateur soudé sur des pistes conductrices électriques est soumis à de grandes contraintes mécaniques, du fait de sa taille, qui peuvent casser les brasures et déplacer le condensateur.

On notera par ailleurs que l'invention n'est pas limitée aux modes de réalisation décrits précédemment. Il apparaîtra en effet à l'homme de l'art que diverses modifications peuvent être apportées aux modes de réalisation décrits cidessus, à la lumière de l'enseignement qui vient de lui être divulgué, et dans les limites imposées par les revendications.

## Revendications

1. Module de puissance (100) comportant :
- un substrat (202) comportant :
• une plaque isolante électrique (204) présentant une face supérieure (206), et
• des pistes conductrices électrique s'étendant sur la face supérieure (206) ;
- un composant électrique (106, 108) fixé contre au moins une des pistes conductrices électriques ;
- une résistance (114) fixée contre au moins une des pistes conductrices électriques ;
- une capacité (116) connectée en série de la résistance (114) ; et
- une encapsulation (302) recouvrant :
• au moins une partie des pistes électriques,
• le composant électrique (106, 108), et
• la résistance (114) ; comportant en outre :
- deux broches (218, 220) présentant :
• des bases fixées à deux des pistes conductrices, ces bases étant recouvertes par l'encapsulation (302); **caractérisé en ce que** les deux broches présentent des extrémités libres se projetant en-dehors de l'encapsulation (302) ; et **en ce que** la capacité (116) est placée en dehors de l'encapsulation (302), et connectée aux extrémités libres des broches (218, 220).

2. Module de puissance (100) selon la revendication 1, comportant en outre une carte de circuit imprimé (402) s'étendant en dehors de l'encapsulation et recevant les extrémités libres des broches (218, 220), et dans lequel la capacité (116) est fixée à la carte de circuit imprimé (402) et connectée par cette dernière aux extrémités libres des broches (218, 220).

3. Module de puissance (100) selon la revendication 2, dans lequel la carte de circuit imprimé (402) porte un circuit de commande du composant électrique (106, 108).

4. Module de puissance (100) selon l'une quelconque des revendications 1 à 3, comportant en outre une borne dite positive (102) et une borne dite négative (104) fixées respectivement à deux des pistes conductrices électriques et conçues pour présenter entre elles une tension continue (U), et dans lequel la résistance (114) et la capacité (116) sont connectées ensemble entre la borne positive (102) et la borne négative (104).

5. Module de puissance (100) selon l'une quelconque des revendications 1 à 4, dans lequel l'encapsulation est en résine.

6. Module de puissance (100) selon l'une quelconque des revendications 1 à 5, dans lequel le composant électrique (106, 108) est un composant électrique semiconducteur.

7. Module de puissance (100) selon la revendication 6, comportant plusieurs composants électriques semiconducteurs (106, 108) formant un bras de commutation.

8. Aéronef comportant un module de puissance (100) selon l'une quelconque des revendications 1 à 7.

9. Procédé de fabrication d'un module de puissance selon l'une quelconque des revendications 1 à 7, comportant :
- une fixation (602) du composant électrique (106, 108) contre au moins une des pistes conductrices électriques, de la résistance (114) contre au moins une des pistes conductrices électriques et des bases des broches (218, 220) respectivement à deux des pistes conductrices électriques ; et
- une encapsulation (604) d'au moins une partie des pistes conductrices électriques, du composant électrique, de la résistance (114) et des bases des broches (218, 220) ; et
**caractérisé en ce qu'**il comporte en outre:
- une connexion (606) de la capacité (116) aux extrémités libres des broches (218, 220), en dehors de l'encapsulation (302).

10. Procédé selon la revendication 9, dans lequel l'encapsulation (604) est réalisée par moulage par transfert de résine.

## Patentansprüche

1. Leistungsmodul (100) umfassend:
- ein Substrat (202) umfassend:
- eine elektrisch isolierende Platte (204), die eine Oberseite (206) aufweist, und
- elektrische Leiterbahnen, die sich über die Oberseite (206) erstrecken;
- ein elektrisches Bauteil (106, 108), das an mindestens einer der elektrischen Leiterbahnen befestigt ist;
- einen Widerstand (114), der an mindestens einer der elektrischen Leiterbahnen befestigt ist;
- einen Kondensator (116), der mit dem Widerstand (114) in Reihe geschaltet ist; und
- eine Kapselung (302), die Folgendes abdeckt:
- mindestens einen Teil der Leiterbahnen,
- das elektrische Bauteil (106, 108), und
- den Widerstand (114);
weiter umfassend:
- zwei Stifte (218, 220) aufweisend:
- Sockel, die an zwei der Leiterbahnen befestigt sind, wobei diese Sockel durch die Kapselung (302) abgedeckt sind;
**dadurch gekennzeichnet, dass** die beiden Stifte freie Enden aufweisen, die aus der Kapselung (302) herausragen, und dadurch, dass der Kondensator (116) außerhalb der Kapselung (302) angeordnet ist und mit den freien Enden der Stifte (218, 220) verbunden ist.

2. Leistungsmodul (100) nach Anspruch 1, weiter umfassend eine Leiterplatte (402), die sich außerhalb der Kapselung erstreckt und die freien Enden der Stifte (218, 220) aufnimmt, und wobei der Kondensator (116) an der Leiterplatte (402) befestigt ist und über diese mit den freien Enden der Stifte (218, 220) verbunden ist.

3. Leistungsmodul (100) nach Anspruch 2, wobei die Leiterplatte (402) eine Steuerschaltung des elektrischen Bauteils (106, 108) trägt.

4. Leistungsmodul (100) nach einem der Ansprüche 1 bis 3, weiter umfassend einen sogenannten positiven Anschluss (102) und einen sogenannten negativen Anschluss (104), die jeweils an zwei der elektrischen Leiterbahnen befestigt sind und so ausgelegt sind, dass zwischen ihnen eine Gleichspannung (U) anliegt, und wobei der Widerstand (114) und der Kondensator (116) gemeinsam zwischen den positiven Anschluss (102) und den negativen Anschluss (104) geschaltet sind.

5. Leistungsmodul (100) nach einem der Ansprüche 1 bis 4, wobei die Kapselung aus Harz besteht.

6. Leistungsmodul (100) nach einem der Ansprüche 1 bis 5, wobei das elektrische Bauteil (106, 108) ein elektrisches Halbleiterbauteil ist.

7. Leistungsmodul (100) nach Anspruch 6, umfassend mehrere elektrische Halbleiterbauteile (106, 108), die einen Schaltzweig bilden.

8. Luftfahrzeug umfassend ein Leistungsmodul (100) nach einem der Ansprüche 1 bis 7.

9. Verfahren zur Anfertigung eines Leistungsmoduls nach einem der Ansprüche 1 bis 7, umfassend:
- eine Befestigung (602) des elektrischen Bauteils (106, 108) an mindestens einer der elektrischen Leiterbahnen, des Widerstands (114) an mindestens einer der elektrischen Leiterbahnen und von Sockel der Stifte (218, 220) jeweils an zwei der elektrischen Leiterbahnen; und
- eine Kapselung (604) mindestens eines Teils der elektrischen Leiterbahnen, des elektrischen Bauteils, des Widerstands (114) und der Sockel der Stifte (218, 220); und
**dadurch gekennzeichnet, dass** es weiter umfasst:
- eine Verbindung (606) des Kondensators (116) mit den freien Enden der Stifte (218, 220) außerhalb der Kapselung (302).

10. Verfahren nach Anspruch 9, wobei die Kapselung (604) durch Harzspritzpressen hergestellt wird.

## Claims

1. A power module (100) comprising:
- a substrate (202) comprising:
• an electrically insulating plate (204) having an upper face (206), and
• electrically conductive tracks extending over the upper face (206);
- an electrical component (106, 108) secured against at least one of the electrical conductive tracks;
- a resistor (114) secured against at least one of the electrical conductive tracks;
- a capacitor (116) connected in series with the resistor (114); and
- an encapsulation (302) covering:
• at least a part of the electrical tracks,
• the electrical component (106, 108), and
• the resistor (114);
further comprising:
- two pins (218, 220) with:
• bases secured to two of the conductive tracks, these bases being covered by the encapsulation (302), and
**characterized in that** the two pins have free ends projecting outside the encapsulation (302);
and **in that** the capacitor (116) is placed outside the encapsulation (302) and connected to the free ends of the pins (218, 220).

2. The power module (100) of claim 1, further comprising a printed circuit board (402) extending out of the encapsulation and receiving the free ends of the pins (218, 220), and wherein the capacitor (116) is secured to the printed circuit board (402) and connected by the latter to the free ends of the pins (218, 220).

3. The power module (100) of claim 2, wherein the printed circuit board (402) carries a control circuit for the electrical component (106, 108).

4. The power module (100) according to any one of claims 1 to 3, further comprising a so-called positive terminal (102) and a so-called negative terminal (104) secured respectively to two of the electrical conductive tracks and adapted to present a DC voltage (U) therebetween, and wherein the resistor (114) and the capacitor (116) are connected together between the positive terminal (102) and the negative terminal (104).

5. The power module (100) according to any one of claims 1 to 4, wherein the encapsulation is made of resin.

6. The power module (100) according to any one of claims 1 to 5, wherein the electrical component (106, 108) is a semiconductor electrical component.

7. The power module (100) according to claim 6, comprising several semiconductor electrical components (106, 108) forming a switching arm.

8. An aircraft comprising a power module (100) according to any one of claims 1 to 7.

9. A method of manufacturing a power module according to any one of claims 1 to 7, comprising:
- securing (602) the electrical component (106, 108) against at least one of the electrical conductive tracks, the resistor (114) against at least one of the electrical conductive tracks and the bases of the pins (218, 220) to two of the electrical conductive tracks respectively; and
- encapsulating (604) at least some of the electrical conductive tracks, the electrical component, the resistor (114) and the bases of the pins (218, 220); and
**characterized in that** it further comprises:
- connecting (606) the capacitor (116) to the free ends of the pins (218, 220), outside the encapsulation (302).

10. The method according to claim 9, wherein the encapsulation (604) is carried out by resin transfer moulding.
